# EUROPEAN PATENT APPLICATION

(11) **EP 4 742 860 A1**
(43) Date of publication of application: **13.05.2026**
(21) Application number: 25171531.4
(22) Date of filing: 21.04.2025
(51) Int. Cl.: H10F 19/90, H10F 77/20

(54) **PHOTOVOLTAIC MODULE**

(30) Priority: 07.11.2024 CN 202411586830; 07.11.2024 CN 202411586872
(71) Applicant: JINKO SOLAR CO., LTD, Jiangxi 334100 (CN); Jinko Solar (Haining) Co., Ltd., Haining City, Zhejiang (CN)
(72) Inventor: TAO, Wusong, Shangrao Economic Development Zone, 334100 (CN); WANG, Luchuang, Shangrao Economic Development Zone, 334100 (CN); HAN, Xiangchao, Shangrao Economic Development Zone, 334100 (CN); HU, Rong, Shangrao Economic Development Zone, 334100 (CN); SONG, Yongqiao, Shangrao Economic Development Zone, 334100 (CN); LIU, Haimei, Shangrao Economic Development Zone, 334100 (CN)
(74) Representative: Balder IP Law, S.L.

(57) **Abstract**

A photovoltaic module is provided and includes cell strings, insulating layers, and bus bars. Each respective cell string of the cell strings includes a plurality of cells sequentially arranged in a first direction, and each respective cell of the plurality of cells is provided with solder ribbons on a back surface of the respective cell and arranged in a second direction intersecting the first direction. A respective insulating layer of the insulating layers is disposed on a side of the solder ribbons away from the respective cell, and the respective insulating layer defines windows, a respective window of the windows to allow an exposed portion of a respective solder ribbon to be exposed through the respective window. A respective bus bar of the bus bars is disposed on a side of the respective insulating layer away from the solder ribbons.

## Description

### TECHNICAL FIELD

The various embodiments described in this document relate in general to the field of photovoltaic technologies, and more specifically to a photovoltaic module.

### BACKGROUND

The back contact (BC) cell includes no electrodes on the front side of the BC cell, which can maximize the use of incident light, reduce optical loss, and have a higher short-circuit current, thereby improving the maximum output power of the BC cell and related modules. In existing BC cell module, the BC cell module still has bus bars on the front side of the BC cell module, and the bus bars occupy part of an area of the front side of the module, thereby reducing the area for arrangement of the cells, and severely limiting the maximum output power of the BC cell module.

### SUMMARY

Embodiments of the disclosure provide a photovoltaic module, which is at least conducive to improving the maximum output power of back contact cell modules.

According to an aspect, embodiments of the disclosure provide a photovoltaic module. The photovoltaic module includes cell strings, insulating layers, and bus bars. Each respective cell string of the cell strings includes a plurality of cells sequentially arranged in a first direction, and each respective cell of the plurality of cells is provided with solder ribbons on a back surface of the respective cell and arranged in a second direction intersecting the first direction, where the solder ribbons disposed on the plurality of cells are configured to connect the plurality of cells in series. A respective insulating layer of the insulating layers is disposed on a side of the solder ribbons away from the respective cell, and the respective insulating layer defines windows, a respective window of the windows to allow an exposed portion of a respective solder ribbon to be exposed through the respective window. A respective bus bar of the bus bars is disposed on a side of the respective insulating layer away from the solder ribbons and extends in the second direction, and the respective bus bar is provided with contact portions, where a respective contact portion of the contact portions recedes toward and abuts on a corresponding exposed portion, to electrically connect the respective bus bar with the respective solder ribbon.

In some embodiments, a corresponding portion of the respective bus bar is recessed toward the corresponding exposed portion with respect to an adjacent portion of the respective bus bar to form the respective contact portion.

In some embodiments, the respective contact portion is arc-shaped.

In some embodiments, the respective contact portion has a size equal to a width of the respective bus bar in the first direction.

In some embodiments, the respective contact portion and the corresponding exposed portion are connected through a conductive adhesive, so that at least a portion of the respective contact portion abuts on the corresponding exposed portion through the conductive adhesive.

In some embodiments, the respective cell string includes a plurality of exposed portions arranged at intervals in the second direction, the respective bus bar is provided with a plurality of contact portions corresponding to the plurality of exposed portions in the respective cell string, and each of the plurality of exposed portions abuts on a corresponding one of the plurality of contact portions.

In some embodiments, the cell strings are arranged in the second direction, and the cell strings are connected in series through the bus bars.

In some embodiments, the respective insulating layer includes a film-coating layer, the film-coating layer is disposed on the respective cell string, and the film-coating layer covers the solder ribbons and a region of the back surface of the respective cell other than the solder ribbons, where the film-coating layer defines openings, and each of the openings forms the respective window.

In some embodiments, the respective insulating layer further includes an insulating spacer layer, the insulating spacer layer is disposed between the film-coating layer and the respective bus bar, and the insulating spacer layer is provided with avoidance structures each communicating with a corresponding opening of the openings.

In some embodiments, the insulating spacer layer is provided in a strip shape and extends in the second direction, the insulating spacer layer defines clearance holes corresponding to the openings, and each of the clearance holes forms a corresponding avoidance structure of the avoidance structures, where the respective contact portion extends into a corresponding clearance hole, and the respective contact portion abuts against an inner wall of the corresponding clearance hole in the second direction.

In some embodiments, the insulating spacer layer includes a plurality of insulating sublayers arranged at intervals in the second direction, and each two adjacent insulating sublayers are spaced by the corresponding opening to form the corresponding avoidance structure between the two adjacent insulating sublayers, where the respective contact portion extends between the two adjacent insulating sublayers, and the respective contact portion abuts against the two adjacent insulating sublayers in the second direction.

### BRIEF DESCRIPTION OF THE DRAWINGS

One or more embodiments are exemplarily illustrated by the accompanying drawings, and these exemplary illustrations do not limit the embodiments, unless otherwise stated, the drawings in the accompanying drawings are not drawn to scale. In order to more clearly illustrate the embodiments of the present disclosure or the technical solutions in the related technologies, the following will briefly introduce the drawings required for the embodiments, obviously, the drawings in the following description are only some embodiments of the present disclosure, and for those skilled in the art, other drawings can be obtained based on these drawings without creative efforts.
FIG. 1 is a schematic structural diagram of a back contact cell module in the prior art.
FIG. 2 is a schematic structural diagram of a photovoltaic module provided in embodiments of the present disclosure.
FIG. 3 is a cross-sectional view of the photovoltaic module in FIG. 2.
FIG. 4 is a partial enlarged view of part A in FIG. 3.
FIG. 5 is a schematic structural diagram of the photovoltaic module in FIG. 2 with bus bars removed.
FIG. 6 is a schematic structural diagram of the photovoltaic module in FIG. 2 with bus bars and s insulating spacer layer removed.
FIG. 7 is a schematic structural diagram of a photovoltaic module provided in other embodiments of the present disclosure.
FIG. 8 is a schematic structural diagram of the photovoltaic module in FIG. 7 with bus bars removed.
FIG. 9 is a schematic structural diagram of an opening in a photovoltaic module provided in other embodiments of the present disclosure.
FIG. 10 is a cross-sectional view of a contact portion in a photovoltaic module provided in embodiments of the present disclosure.
FIG. 11 is a schematic structural diagram of a photovoltaic module provided in other embodiments of the present disclosure.
FIG. 12 is a cross-sectional view of the photovoltaic module in FIG. 11.
FIG. 13 is a partial enlarged view of part B in FIG. 12.
FIG. 14 is a schematic structural diagram of a photovoltaic module provided in embodiments of the present disclosure.

### DETAILED DESCRIPTION OF THE EMBODIMENTS

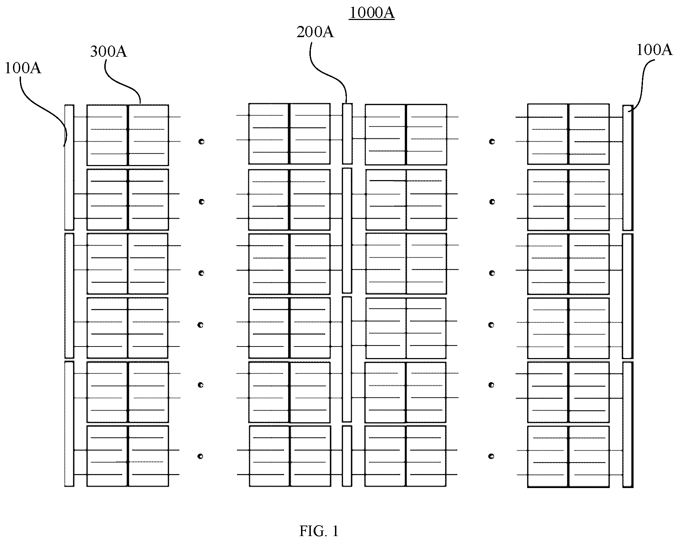

In view of the above, referring to FIG. 1, in the existing back contact cell module 1000A, the back contact cell module 1000A still includes head and tail bus bars 100A and intermediate bus bars 200A on the front side of the back contact cell module 1000A. Therefore, when the size of the back contact cell module 1000A is constant, since the head and tail bus bars 100A and the intermediate bus bars 200A occupy part of an area on the front side of the back contact cell module 1000A, the area for laying the cells 300A can be reduced, thereby severely limiting the maximum output power of the back contact cell module 1000A.

The present disclosure provides a photovoltaic module, bus bars of the photovoltaic module are hidden on the back side of the cells, so the bus bars do not occupy the area on the front side of the photovoltaic module, thereby maximizing the laying area of the cells and increasing the light-receiving area on the front side of the photovoltaic module, thus improving the maximum output power of the photovoltaic module. In addition, by changing the shape of each bus bar to form contact portions on the bus bar, each contact portion of the bus bar abuts against/contacts a corresponding exposed portion of a corresponding solder ribbon, so that the bus bar and the solder ribbons are welded through the contact portions and the exposed portions. In this way, it is possible to reduce the offset of the bus bar due to sudden local force during the welding, and allow the bus bar to better contact the solder ribbons, thereby effectively reducing the risk of micro-cracks and fragmentation of the cells during subsequent lamination, and reducing the possibility of virtual soldering/poor soldering between the bus bars and the solder ribbons.

In the illustration of the embodiments of the present disclosure, the technical terms "first", "second", etc. are only used to distinguish different objects, and could not be understood as indicating or implying relative importance or implicitly indicating the number, specific order, or primary-secondary relationship of the indicated technical features. In the illustration of the embodiments of the present disclosure, "a plurality of/multiple" means two or more, unless otherwise explicitly and specifically defined. Similarly, "multiple groups" refers to two or more groups (including two groups), and "multiple pieces" refers to two or more pieces (including two pieces).

The mention of "embodiments" herein means that the specific features, structures, or characteristics described in the embodiments can be included in at least one embodiment of the present disclosure. The appearance of the phrase in various places in the specification does not necessarily refer to the same embodiment, nor is it an independent or alternative embodiment that is mutually exclusive with other embodiments. Those skilled in the art explicitly and implicitly understand that the embodiments described herein can be combined with other embodiments.

In the illustration of the embodiments of the present disclosure, the term "and/or" is only a description of the association relationship of the associated objects, indicating that there can be three relationships, for example, A and/or B, which can mean: there is A, there is both A and B, and there is B. In addition, the character "/" herein generally indicates that the associated objects before and after are in an "or" relationship.

In the illustration of the embodiments of the present disclosure, the technical terms "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential", etc. indicate the orientation or positional relationship based on the orientation or positional relationship shown in the drawings, and are only for the convenience of describing the embodiments of the present disclosure and simplifying the illustration, rather than indicating or implying that the device or element referred to must have a specific orientation, be constructed and operated in a specific orientation, and therefore cannot be understood as a limitation of the embodiments of the present disclosure. For example, if the device or element in the drawing is inverted, the element described as being "below", "under", "lower", or "bottom" of other elements or features will be oriented "above" or "top" of the other elements or features. Therefore, the term "below" can cover both orientations of above and below depending on the context in which the term is used, which will be obvious to those skilled in the art. The material can be oriented in other ways (for example, rotated 90 degrees, inverted, flipped), and the spatial relative descriptors used in this article can be interpreted accordingly.

In the illustration of the embodiments of the present disclosure, unless otherwise explicitly specified and defined, the technical terms "installation/mounted", "connected/coupled", "connection", "fixed", etc. should be understood in a broad sense, for example, may indicate a fixed connection, a detachable connection, or may indicate an integrated formation. Alternatively, the technical terms may also indicate a mechanical connection, an electrical connection. Alternatively, the technical terms may indicate a direct connection, or indirectly connection through an intermediate medium, or may indicate an internal communication between two elements or the interaction relationship between two elements. For those skilled in the art, the specific meaning of the above terms in the embodiments of the present disclosure can be understood according to specific circumstances.

In the drawings corresponding to the embodiments of the present disclosure, for better understanding and description, the thickness and area of the layers are enlarged. In addition, when describing that a component is "substantially" formed on another component, it means that the component is not formed on the entire surface (or front surface) of the other component, nor is it formed on part of the edge of the entire surface.

In the illustration of the embodiments of the present disclosure, when a component "includes" another component, unless otherwise specified, it does not exclude other components, and other components may also be further included. The formation or setting of a second component on or above a first component, or the formation or setting of a second component on the surface of a first component, or the formation or setting of a second component on one side of a first component, can include embodiments where the first component and the second component are in direct contact, and can also include embodiments where additional components can be present between the first component and the second component, so that the first component and the second component may not be in direct contact. For simplicity and clarity, various components may be drawn arbitrarily at different scales. In the drawings, some layers/components may be omitted for simplicity. Unless otherwise specified, a second member is formed or provided on the surface of the first member means that the first member is in direct contact with the second member. Here, the "component/member" may refer to a layer, a film, a region, a portion, a structure, and the like.

The terminology used in the illustration of the various described embodiments herein is for the purpose of describing particular embodiments only and is not intended to be limiting. As used in the description of the various embodiments described and in the appended claims, "the components" are also intended to include the plural form unless the context clearly dictates otherwise. The components include layers, films, regions, or plates, and the like.

Hereinafter, embodiments of the present disclosure will be described in detail with reference to the accompanying drawings. However, one of ordinary skill in the art will appreciate that in various embodiments of the present disclosure, many technical details are set forth in order to better understand the present disclosure by the reader. However, even without these technical details and various changes and modifications based on the following embodiments, the technical solutions claimed by the present disclosure can be realized.

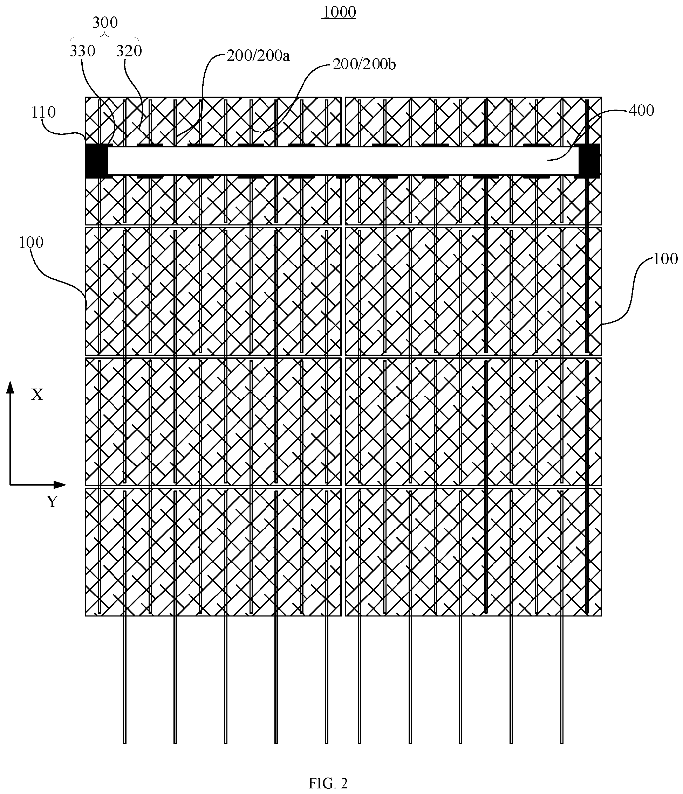

FIGS. 2 to 9 are schematic structural diagrams of various photovoltaic modules provided in embodiments of the present disclosure.

Referring to FIGS. 2 to 4, the photovoltaic module 1000 includes a plurality of cell strings 100, insulating layers 300, and bus bars 400. Each of the plurality of cell strings 100 includes a plurality of cells 110 sequentially arranged in a first direction X. Each respective cell 110 of the plurality of cells 110 is provided with solder ribbons 200 on a back surface of the respective cell 110 and arranged in a second direction Y intersecting the first direction X, where the solder ribbons 200 disposed on the plurality of cells 110 are configured to connect the plurality of cells 110 in series. A respective insulating layer 300 of the insulating layers 300 is provided on a side of the solder ribbons 200 away from the respective cell 110. The respective insulating layer 300 defines windows 310, a respective window 310 of the windows 310 to allow an exposed portion 210 of a respective solder ribbon 200 to be exposed through the respective window 310. A respective bus bar 400 of the bus bars 400 is provided on a side of the respective insulating layer 300 away from the solder ribbons 200. The respective bus bar 400 is provided with contact portions 410, where a respective contact portion 410 of the contact portions 410 recedes toward and abuts on a corresponding exposed portion 210 of the respective solder ribbon 200, to electrically connect the respective bus bar 400 and the respective solder ribbon 200.

Specifically, the photovoltaic module 1000 is a back contact cell module. That is, the photovoltaic module 1000 includes back contact cells. The photovoltaic module 1000 includes a plurality of cell strings 100 connected in series, and each cell string 100 includes a plurality of cells 110 connected in series. Each cell 110 is generally a sheet-like structure, and the cell 110 has a front surface (or light absorbing surface) and a back surface opposite in a thickness direction of the cell 110. The front surface of the cell 110 can absorb light energy and convert the light energy into electrical energy. The cell 110 includes first grid lines (electrodes) and second electrodes on the back surface of the cell 110. One of the first electrode and the second electrode is a positive electrode and the other of the first electrode and the second electrode is a negative electrode. That is, the first electrode and the second electrode have different conductivity types. There are solder ribbons 200 disposed on the back surface of the respective cell 110, and each solder ribbon 200 of the solder ribbons 200 extends in an arrangement direction of the plurality of cells 110 in a respective cell string 100 (first direction X). The solder ribbons 200 include a plurality of first solder ribbons 200a and a plurality of second solder ribbons 200b. The plurality of first solder ribbons 200a and the plurality of second solder ribbons 200b are alternatingly disposed on the back surface of the respective cell 110 in a width direction of the respective cell string 100 (in the second direction Y). A respective first solder ribbon 200a of the plurality of first solder ribbons 200a is electrically connected to a respective first electrode of the plurality of first electrodes, and a respective second solder ribbon 200b of the plurality of second solder ribbons 200b is electrically connected to a respective second electrode of the plurality of second electrodes. In this way, current of the first electrodes can be conducted by the first solder ribbons 200a, the current of the second electrodes can also be conducted by the second solder ribbons 200b, and the plurality of cells 110 in the respective cell string 100 are connected in series by the first solder ribbons 200a and the second solder ribbons 200b on the back surface of each cell 110.

The respective insulating layer 300 is provided on the side of the solder ribbons 200 away from the respective cell 110. That is, the respective insulating layer 300 covers the solder ribbons 200 and a region of the back surface of the respective cell other than the solder ribbons 200. The respective insulating layer 300 defines windows 310. A portion of the respective solder ribbon 200 facing the respective window 310 of the windows 310 in a thickness direction of the respective cell 110 (in a direction perpendicular to the back surface of the respective cell 110) is defined as an exposed portion 210. That is, the respective window 310 exposes the corresponding exposed portion 210 of the respective solder ribbon 200. In other words, the exposed portion 210 of the respective solder ribbon 200 is not covered by the respective insulating layer 300, and another portion of the respective solder ribbon 200 except the exposed portion 210 is covered by the respective insulating layer 300. The respective bus bar 400 is provided on the side of the respective insulating layer 300 away from the solder ribbons 200. A shape of a portion of the respective bus bar 400 facing the exposed portions 210 in the thickness direction of the respective cell 110 is changed to form the contact portions 410 on the respective bus bar 400 corresponding to the exposed portions 210. The respective contact portion 410 faces the corresponding exposed portion 210 in the thickness direction of the respective cell 110. At least a part of the respective contact portion 410 extends/inserts into the respective window 310 of the insulating layer 300, to abut against (contact) the corresponding exposed portion 210, enabling the respective bus bar 400 to be welded to the respective solder ribbon 200 via the respective contact portion 410 and the corresponding exposed portion 210.

The respective bus bar 400 is electrically connected to the respective solder ribbon 200, specifically, the respective bus bar 400 is electrically connected to a corresponding first solder ribbon 200a or a corresponding second solder ribbon 200b. For example, referring to FIGS. 2 to 4, in some embodiments, the respective insulating layer 300 defines a window 310 corresponding to each of the first solder ribbons 200a, each of the first solder ribbons 200a includes a corresponding exposed portion 210, and the respective bus bar 400 and each of the first solder ribbons 200a are electrically connected through the corresponding exposed portion 210 and the respective contact portion 410. For another example, in other embodiments, the respective insulating layer 300 defines a window 310 corresponding to each of the second solder ribbons 200b, each of the second solder ribbons 200b includes a corresponding exposed portion 210, and the respective bus bar 400 and each of the second solder ribbons 200b are electrically connected through the corresponding exposed portion 210 and the respective contact portion 410. Hereinafter, the following describes the respective bus bar 400 and each of the first solder ribbons 200a being electrically connected through the corresponding exposed portion 210 and the respective contact portion 410 as an example of the respective bus bar 400 being electrically connected with the respective solder ribbon 200.

The bus bars 400 of the photovoltaic module 1000 are disposed on the back surface of each of the cells 110. In other words, the bus bars 400 do not occupy the area of the front surface of the photovoltaic module 1000, thereby maximizing the laying area of the cells 110, increasing the illumination area of the front surface of the photovoltaic module 1000, and thus, increasing the maximum output power of the photovoltaic module 1000. In addition, by changing the shape of each of the bus bars 400, the contact portions 410 are formed on the bus bar 400, so that each of the contact portions 410 of the bus bar 400 and the exposed portion 210 of each of the solder ribbons 200 are abutted. In this way, the bus bar 400 and the solder ribbon 200 are welded by the contact portion 410 and the exposed portion 210, which not only reduces the offset of the bus bar 400 due to sudden local stress during welding of the bus bar 400, but also makes the bus bar 400 better contact with the solder ribbon 200, thereby effectively reducing the risk of microcracks and breakage of the cells 110 in the subsequent lamination process, and reducing the possibility of poor soldering between the bus bar 400 and the solder ribbons 200.

Hereinafter, embodiments of the present disclosure will be described in more detail with reference to the accompanying drawings.

The contact portions 410 are formed on each of the bus bars 400 by changing the shape of each bus bar 400. Therefore, there are many specific manners for forming the contact portions 410. For example, a portion of the respective bus bar 400 facing the exposed portions 210 is thickened to form protrusions (i.e., a thickened portion) on a surface of the respective bus bar 400 close to the exposed portions 210, and the protrusions can be regarded as the contact portions 410 of the respective bus bar 400. For another example, a portion of the respective bus bar 400 facing the exposed portions 210 is subjected to a bending deformation, and the portion subjected to the bending deformation can be regarded as the contact portions 410.

Referring to FIGS. 2 to 4, in some embodiments, a corresponding portion of the respective bus bar 400 is recessed toward the corresponding exposed portion 210 with respect to an adjacent portion of the respective bus bar 400 to form the respective contact portion 410.

Specifically, the corresponding portion of the respective bus bar 400 facing the corresponding exposed portion 210 is recessed toward the corresponding exposed portion 210, and the recessed portion of the respective bus bar 400 extends into the respective window 310 of the respective insulating layer 300 to abut against the corresponding exposed portion 210, so that the recessed portion of the respective bus bar 400 forms the corresponding contact portion 410. This manner of forming the contact portions 410 can be achieved by stamping an existing bus bar 400, causing a local recess in the bus bar 400 to form the contact portions 410. The manufacturing cost of the bus bar 400 with such a special shape is relatively low.

There is no restriction on the specific shape of the respective recessed contact portion 410, and the respective contact portion 410 may be provided in a shape such as a square, a trapezoid, or an arc. Referring to FIGS. 2 to 4, in some embodiments, the respective contact portion 410 may have an arc shape. The arc-shaped contact portion 410 is relatively easy to manufacture and can also avoid stress concentration at the contact portion 410.

The respective contact portion 410 has a width in a width direction of the respective bus bar 400 (that is, an extending direction of the solder ribbon, or the first direction X). The width of the respective contact portion 410 may be equal to or less than a width of the respective bus bar 400 in the first direction X. Referring to FIGS. 2 to 4, in some embodiments, the dimension/width of the respective contact portion 410 in the width direction of the respective bus bar 400 is equal to the width of the respective bus bar 400. In this way, by making the contact portion 410 widest, it is possible not only to reduce the processing difficulty of the contact portion 410, but also to increase the effective conductive area between the contact portion 410 and the exposed portion 210.

In other embodiments, a conductive adhesive is provided between the respective contact portion 410 and the corresponding exposed portion 210, so that at least a portion of the respective contact portion 410 abuts on the corresponding exposed portion 210 through the conductive adhesive. By providing the conductive adhesive between the respective contact portion 410 and the corresponding exposed portion 210, the effective conductive area between the contact portion 410 and the exposed portion 210 can be increased, and the possibility of false/poor welding between the contact portion 410 and the exposed portion 210 can be reduced.

Referring to FIGS. 2, 5, and 6, each respective cell string 100 is generally provided with a plurality of first solder ribbons 200a in a width direction of the respective cell string 100 (the second direction Y), and the plurality of first solder ribbons 200a are electrically connected by a respective bus bar 400. For example, referring to FIGS. 2, 5, and 6, in some embodiments, the respective cell string 100 includes a plurality of exposed portions 210 arranged at intervals in an extending direction of the respective bus bar 400 (the second direction Y), and the respective bus bar 400 is provided with a plurality of contact portions 410 corresponding to the plurality of exposed portions 210 in the respective cell string 100. Each of the plurality of exposed portions 210 abuts on a corresponding one of the plurality of contact portions 410. The respective insulating layer 300 defines a plurality of windows 310 arranged at intervals in the extending direction of the respective bus bar 400, so that a plurality of exposed portions 210 of the respective cell string 100 that are arranged at intervals in the extending direction of the respective bus bar 400 may be exposed. The extending direction of the respective bus bar 400 is perpendicular to or approximately perpendicular to a longitudinal direction (extending direction) of the respective solder ribbon 200. In this way, the cells 110 may be arranged more densely, which is beneficial to increasing the laying area of the cells 110.

Referring to FIGS. 2, 5, and 6, the photovoltaic module 1000 generally includes a plurality of cell strings 100, and the plurality of cell strings 100 are connected in series by bus bars 400. For example, with reference to FIGS. 2, 5, and 6, in some embodiments, the plurality of cell strings 100 are arranged in the extending direction of the respective bus bar 400, and the plurality of cell strings 100 are connected in series by the bus bars 400. In this way, the cells 110 may be arranged more densely, which is beneficial to increasing the laying area of the cells 110.

It shall be noted that the figures merely illustrate one bus bar for illustrative purposes, in the actual solutions, there may be a plurality of busbars, so that current of all the first solder ribbons on the cells of each of the plurality of cell strings can be collected by the plurality of bus bars. In addition, it shall be noted that in the disclosure, the bus bar electrically connected to the first solder ribbons can be regarded as a first type of bus bars (e.g., first bus bars), and there may be second type of busbars (second bus bars) to electrically connect the second solder ribbons on the cells of each of the plurality of cell strings. For the manner in which a respective second bus bar is electrically connected to a corresponding second solder ribbon, reference may be made to the related portions at which the respective bus bar is electrically connected to the respective first solder ribbon, which will not be repeated herein.

The respective insulating layer 300 is provided between the respective bus bar 400 and the solder ribbons 200, and the respective insulating layer 300 is configured to insulate the respective bus bar 400 from the second solder ribbons 200b and the second electrodes of the respective cell 110. Since the respective insulating layer 300 defines a respective window 310 corresponding to the exposed portion 210 of each of the first solder ribbons 200a, the respective contact portion 410 of the respective bus bar 400 can extend into the window 310 and abut on the corresponding exposed portion 210 of the corresponding first solder ribbon 200a, thereby electrically connecting the respective bus bar 400 and the first solder ribbons 200a.

The insulating layer 300 can be provided in a variety of ways. For example, the insulating layer 300 may be an insulating glue, an insulating tape, an insulating film, or the like. Referring to FIGS. 2, 5, and 6, in some embodiments, the respective insulating layer 300 includes a film-coating layer 320, the film-coating layer 320 is disposed on the respective cell string 100, and the film-coating layer 320 covers the solder ribbons 200 and a region of the back surface of each of the cells 110 other than the solder ribbons 200. The film-coating layer 320 defines openings 321, and each of the openings 321 forms the respective window 310.

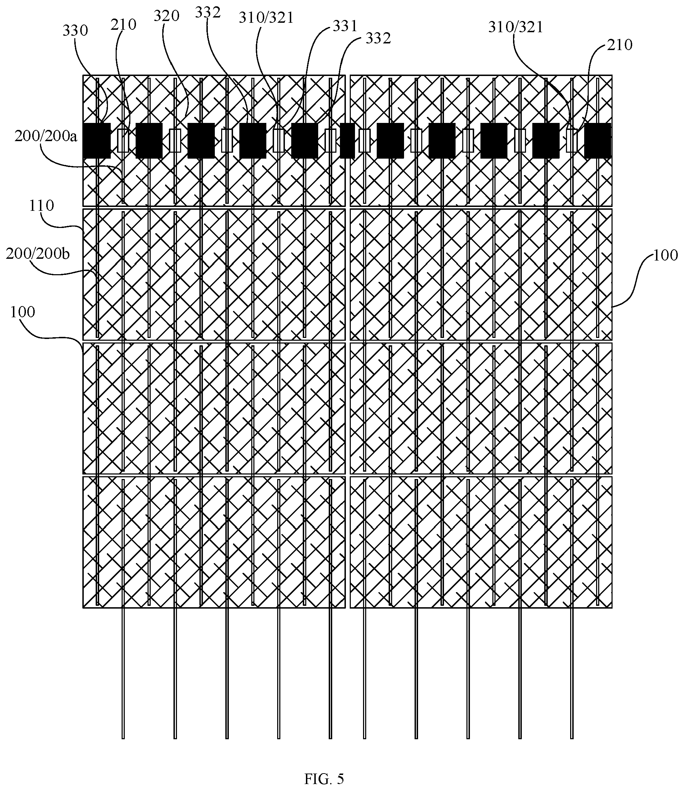

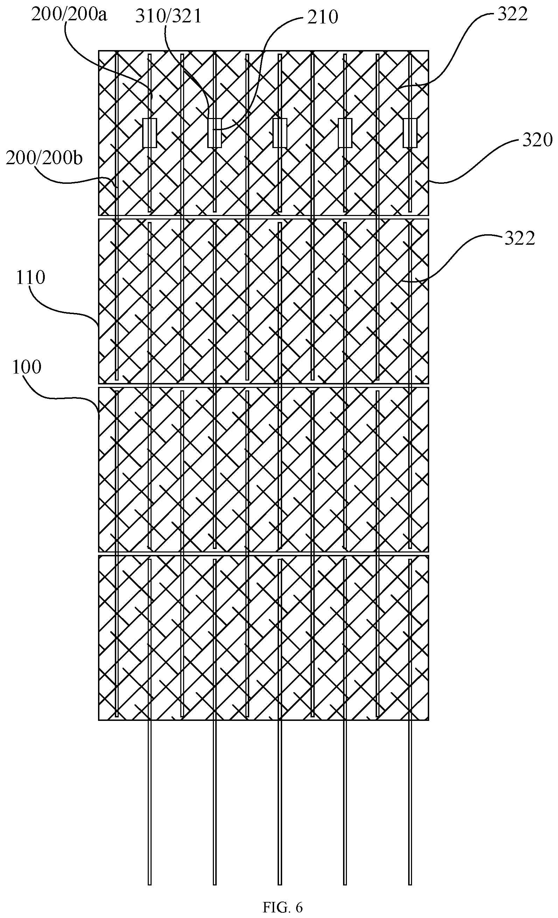

Specifically, the film-coating layer 320 is an insulating film, and the film-coating layer 320 defines the openings 321. The openings 321 form the windows 310, respectively. There is no restriction on the specific shape of each of the openings 321, and each opening 321 may be provided in a shape such as a square hole, a circular hole, or a diamond hole. For example, referring to FIGS. 5 and 6, in some embodiments, the opening 321 is a square hole.

The film-coating layer 320 may be provided on the back surface of each of the cells 110 by a low-temperature film-coating technique, for example, the cells 110 are placed first; after positioning of the cells 110, solder ribbons 200 are placed on each of the cells; and then a film-coating layer 320 is laid, and the film-coating layer 320 is opened and finally heated and pressurized, so that the solder ribbons 200 are fixed on each of the cells 110 by the film-coating layer 320. The film-coating layer 320 is disposed on the back surface of each of the cells 110 using the low-temperature film-coating technology, which can reduce the warpage of each cell 110. In addition, the film-coating layer 320 can protect most of the electrode regions of each of the cells 110, thus preventing the cell 110 from short-circuiting by tin explosion generated by welding of the bus bar 400. There is no restriction on the material of the film-coating layer 320, which may be selected according to the actual situation. For example, the film-coating layer 320 may be an ethylene-vinyl acetate copolymer (EVA) film, a polyethylene octene co-elastomer (POE) film, an EP film (two-layer co-extruded film of EVA and POE), an EPE film (three-layer co-extruded film of EVA and POE), or the like.

The film-coating layer 320 covers the back surface of each cell 110 in the respective cell string 100, and the film-coating layer 320 is specifically disposed in various ways. For example, referring to FIG. 6, in some embodiments, the film-coating layer 320 includes a plurality of film-coating sublayers 322. The plurality of film-coating sublayers 322 are disposed in one-to-one correspondence with the plurality of cells 110 in the respective cell string 100, and each of the plurality of film-coating sublayers 322 covers the back surface of a corresponding one of the plurality of cells 110. The shape and size of each film-coating sublayer 322 are adapted to the shape and size of the cell 110, and the plurality of film-coating sublayers 322 are respectively provided on the back surfaces of the plurality of cells 110 in the respective cell string 100. In other words, the plurality of film-coating sublayers 322 are not connected as a whole, so that the film-coating layer 320 can be formed by the plurality of sheet-shaped film-coating sublayers 322, which can reduce the installation area of the film-coating layer 320 and the material amount of the film-coating layer 320.

For another example, in other embodiments, the film-coating layer 320 is extended in the extending direction of the respective cell string 100 (first direction X). A dimension/length of the film-coating layer 320 in the extending direction of the respective cell string 100 is equal to a length of the respective cell string 100. The length of the film-coating layer 320 is equal to or approximately equal to the length of the respective cell string 100 in the first direction X, which may ensure that the back surface of each cell 110 in the respective cell string 100 can be completely covered by the film-coating layer 320, and further enable the solder ribbons 200 connecting two adjacent cells 110 to be completely covered by the film-coating layer 320.

Referring to FIGS. 2 to 4, in some embodiments, the respective insulating layer 300 further includes an insulating spacer layer 330. The insulating spacer layer 330 is disposed between the film-coating layer 320 and the respective bus bar 400. The insulating spacer layer 330 defines avoidance structures 331 each communicating with a corresponding one of the openings 321.

Specifically, by providing the insulating spacer layer 330 between the film-coating layer 320 and the bus bar 400, a thickness of the respective insulating layer 300 at a junction between the respective bus bar 400 and the corresponding solder ribbon 200 is a sum of a thickness of the film-coating layer 320 and a thickness of the insulating spacer layer 330. In this way, it is advantageous to ensure that the insulating layer 300 has a sufficient thickness at the junction between the bus bar 400 and the solder ribbon 200, thereby ensuring the insulating effect of the insulating layer 300. The insulating spacer layer 330 may be an insulating glue, an insulating tape, an insulating film, or the like.

The thermoplasticity of the film-coating layer 320 is generally better than the thermoplasticity of the insulating spacer layer 330, which can ensure that the film-coating layer 320 can have a better film-coating effect, and can further ensure that the insulating layer 300 has a sufficient thickness at the connection between the bus bar 400 and the solder ribbon 200 by disposing the insulating spacer layer 330. The specific material of the insulating spacer layer 330 may be selected according to the actual situation. For example, the insulating spacer layer 330 may be a polyethylene terephthalate (PET) adhesive film, a polyimide (PI) adhesive film, or the like.

The insulating spacer layer 330 ensures that the insulating layer 300 has a sufficient thickness at the connection between the bus bar 400 and the solder ribbon 200. The specific thickness of the insulating spacer layer 330 can be determined according to the actual situation. In some embodiments, the thickness of the insulating spacer layer 330 is in a range of 0.03 mm to 0.2 mm in a direction perpendicular to the back surface of the respective cell.

Specifically, the thickness of the insulating spacer layer 330 is in a range of 0.03mm to 0.2 mm. For example, the thickness of the insulating spacer layer 330 may be 0.03 mm, 0.04 mm, 0.05 mm, 0.06 mm, 0.07 mm, 0.08 mm, 0.09 mm, 0.1 mm, 0.11 mm, 0.12 mm, 0.13 mm, 0.14 mm, 0.15 mm, 0.16 mm, 0.17 mm, 0.18 mm, 0.19 mm, 0.2 mm, or the like. In this way, by controlling the thickness of the insulating spacer layer 330 to be within the above range, the insulating layer 300 can be ensured to maintain a sufficient thickness at the connection between the bus bar 400 and the solder ribbon 200. In this way, it is possible to prevent the insulating spacer layer 330 from being too thin, which makes the operation convenient (e.g., not easy to deform when pulling) when pasting the insulating spacer layer 330, and reduce the risk of damage to the long-term insulation. In addition, it is further possible to prevent the insulating spacer layer 330 from being too thick, which may reduce the height difference between the bus bar 400 and the solder ribbon 200, increasing the risk of microcracks or cell breakage in the cells 110 in the subsequent lamination processes.

The insulating spacer layer 330 is provided between the film-coating layer 320 and the bus bar 400. The insulating spacer layer 330 is generally disposed in the extending direction of the respective bus bar 400. The insulating spacer layer 330 has a dimension/width larger than or equal to the width of the respective bus bar 400 in the width direction of the respective bus bar 400 (i.e., the extending direction of the solder ribbon, or the first direction X).

Referring to FIGS. 2 and 5, in some embodiments, the insulating spacer layer 330 includes a plurality of insulating sublayers 332 disposed at intervals in the extending direction of the respective bus bar 400. Each two adjacent insulating sublayers 332 are spaced by an opening 321 to form an avoidance structure 331 between the two adjacent insulating sublayers 332.

Specifically, each insulating sublayer 332 is configured in a block-shaped form. The plurality of insulating sublayers 332 are arranged at intervals in the extending direction of the respective bus bar 400 to form the insulating spacer layer 330. The plurality of insulating sublayers 332 and the plurality of openings 321 of the film-coating layer 320 are alternatingly arranged in the extending direction of the respective bus bar 400. A gap between two insulating sublayers 332 on both sides of each opening 321 forms an avoidance structure 331, thereby enabling the insulating spacer layer 330 to define the plurality of avoidance structures 331 corresponding to the plurality of openings 321 in the film-coating layer 320. A spacing between any two adjacent insulating sublayers 332 is greater than or equal to a dimension of a corresponding opening 321 in the extending direction of the respective bus bar 400. In this way, by forming the insulating spacer layer 330 by the plurality of insulating sublayers 332, it is possible to reduce the installation area of the insulating spacer layer 330 and reduce the material amount of the insulating spacer layer 330.

The number of insulating sublayers 332 may be smaller than the number of openings 321. Alternatively, the number of insulating sublayers 332 may be equal to the number of openings 321. Alternatively, the number of insulating sublayers 332 may also be larger than the number of openings 321. Referring to FIGS. 2 and 5, in some embodiments, the plurality of openings 321 are defined at intervals in the extending direction of the respective bus bar 400, and there are insulating sublayers 332 provided on both sides of each opening 321 in the extending direction of the respective bus bar 400.

Specifically, the number of insulating sublayers 332 is larger than the number of openings 321, so that there are two insulating sublayers 332 distributed on both sides of each opening 321. In this way, the insulating sublayer 332 is provided on each of the both sides of each opening 321, such that the gap between the bus bar 400 and the film-coating layer 320 can be reduced, and the contact position between the bus bar 400 and the solder ribbon 200 can be relatively flat.

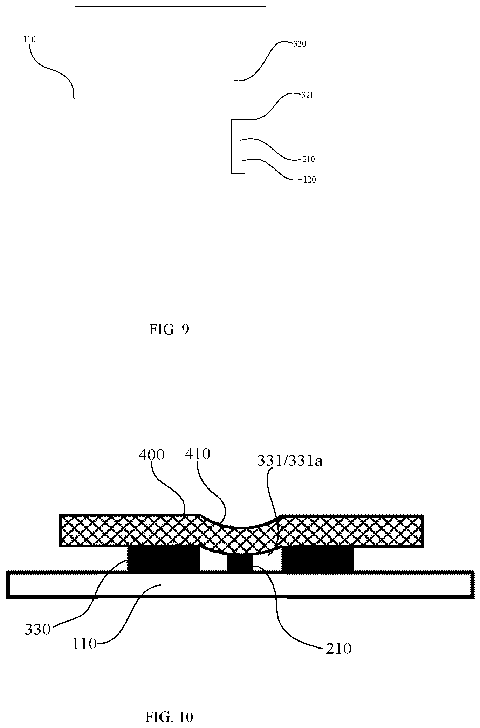

Referring to FIG. 10, in some embodiments, the respective contact portion 410 extends between a corresponding pair of adjacent insulating sublayers 332, with the respective contact portion 410 abutting against the corresponding pair of adjacent insulating sublayers 332 in the extending direction of the respective bus bar 400.

Specifically, a size of the respective contact portion 410 in the extending direction of the respective bus bar 400 (the arrangement direction of the cell strings) is regarded as a length of the respective contact portion 410. When the respective contact portion 410 has an arc shape, the respective contact portion 410 has a plurality of lengths in the extending direction of the respective bus bar 400. A longest length of the respective contact portion 410 is equal to or approximately equal to a distance between the two adjacent insulating sublayers 332, so that the respective contact portion 410 can abut against the two adjacent insulating sublayers 332 in the extending direction of the respective bus bar 400, thereby reducing the displacement of the respective bus bar 400 in the longitudinal direction of the bus bar 400 caused by sudden localized stress concentrations.

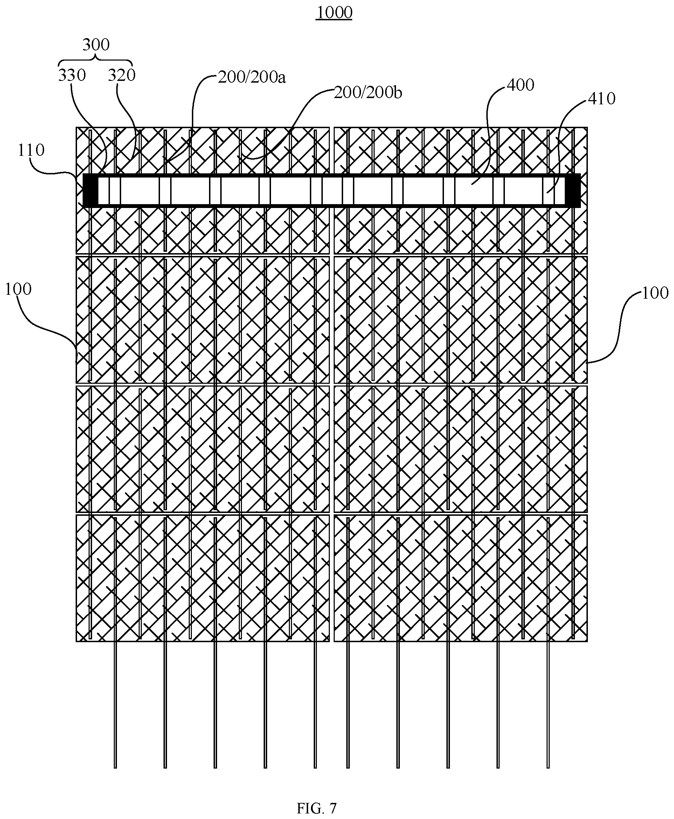

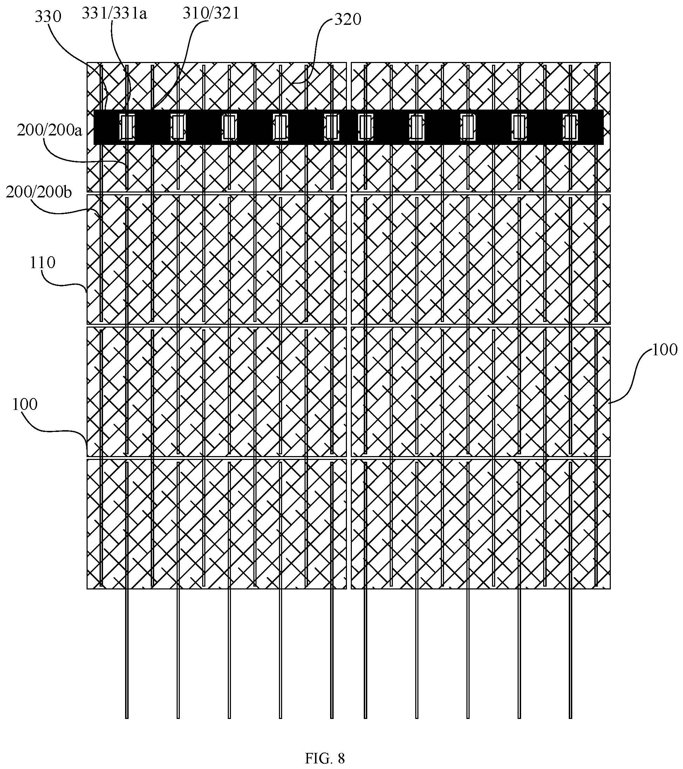

Referring to FIGS. 7 and 8, in some embodiments, the respective insulating spacer layer 330 is provided in a strip shape extending in the extending direction of the respective bus bar 400, and the respective insulating spacer layer 330 defines clearance holes 331a corresponding to the openings 321, where each of the clearance holes 331a forms a corresponding avoidance structure 331.

Specifically, a shape of the respective insulating spacer layer 330 is adapted to a shape of the respective bus bar 400, and the respective insulating spacer layer 330 is provided in an elongated strip shape. A length of the respective insulating spacer layer 330 (in the extending direction of the respective bus bar) is greater than or equal to the length of the respective bus bar 400, and a width of the respective insulating spacer layer 330 (in the extending direction of the solder ribbon) is greater than or equal to a width of the respective bus bar 400. For example, the length of the insulating spacer layer 330 may be slightly larger than the length of the bus bar 400, and the width of the insulating spacer layer 330 may also be slightly larger than the width of the bus bar 400. The respective insulating spacer layer 330 defines a plurality of clearance holes 331a corresponding to the openings 321 of the film-coating layer 320, and each of the plurality of clearance holes 331a communicates with a corresponding one of the openings 321. A size of a respective clearance hole 331a may be greater than or equal to a size of a respective opening 321, and the respective clearance hole 331a is generally shaped to match the respective opening 321. For example, referring to FIGS. 7 and 8, in some embodiments, the clearance holes 331a and the openings 321 include square holes. By providing the insulating spacer layer 330 in an elongated strip shape, a gap between the bus bar 400 and the film-coating layer 320 can be avoided, and the contact position between the bus bar 400 and the solder ribbon 200 can be relatively flat.

Referring to FIG. 10, in some embodiments, the respective contact portion 410 extends into a corresponding clearance hole 331a, and the respective contact portion 410 abuts on an inner hole wall of the corresponding clearance hole 331a in the extending direction of the respective bus bar 400.

Specifically, a size of the clearance hole 331a in the arrangement direction of the solder ribbon 200 (that is, the extending direction of the respective bus bar 400) is regarded as a width of the clearance hole 331a. The longest length of the contact portion 410 is equal to or approximately equal to the width of the clearance hole 331a, so that the contact portion 410 can abut on two inner hole walls of the clearance hole 331a opposite to each other in the extending direction of the respective bus bar 400, thereby reducing the displacement of the bus bar 400 in the extending direction of the respective bus bar 400 due to sudden local force.

In other embodiments, the respective contact portion 410 extends into a corresponding clearance hole 331a, and the respective contact portion 410 abuts on an inner hole wall of the corresponding clearance hole 331a in the width direction of the respective bus bar 400 (in the extending direction of the solder ribbon).

Specifically, a dimension of the clearance hole 331a in the extending direction of the solder ribbon 200 (that is, the width direction of the bus bar 400) is regarded as a length of the clearance hole 331a. A maximum width of the contact portion 410 in the extending direction of the solder ribbon 200 is equal to or approximately equal to the length of the clearance hole 331a, so that the contact portion 410 can abut on two inner hole walls of the clearance hole 331a opposite to each other in the extending direction of the solder ribbon, thereby reducing the displacement of the bus bar 400 in the width direction of the bus bar 400 due to sudden local force.

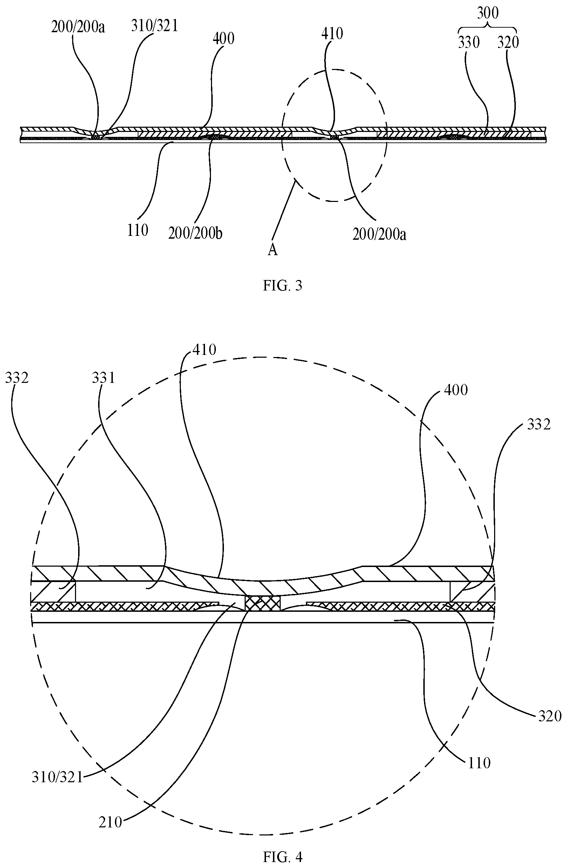

Each solder ribbon 200 has a thickness less than a sum of a thickness of the film-coating layer 320 and a thickness of the insulating spacer layer 330 and the thickness of the solder ribbon 200 may be greater than the thickness of the film-coating layer 320, in a direction perpendicular to the back surface of the respective cell. Alternatively, the thickness of the solder ribbon 200 may be equal to the thickness of the film-coating layer 320. Alternatively, the thickness of the solder ribbon 200 may also be less than the thickness of the film-coating layer 320. Referring to FIG. 4, in some embodiments, a surface of the exposed portion 210 away from the cell 110 is located on a side of the film-coating layer 320 close to the insulating spacer layer 330, and a surface of the insulating spacer layer 330 close to the bus bar 400 is located on the side of the exposed portion 210 away from the cell 110.

Specifically, if a width of the respective opening is larger than a width of the respective solder ribbon 200 in the second direction Y, and the thickness of the solder ribbon 200 is greater than the thickness of the film-coating layer 320, the surface of the exposed portion 210 away from the cell 110 is located on a side of a portion of the film-coating layer 320, that does not cover the solder ribbon 200, close to the insulating spacer layer 330. That is, the exposed portion 210 extends toward the bus bar 400 to the outside of the opening 321 of the film-coating layer 320. The thickness of the solder ribbon 200 is less than the sum of the thickness of the film-coating layer 320 and the thickness of the insulating spacer layer 330, so that the surface of the insulating spacer layer 330 close to the bus bar 400 is located on the side of the exposed portion 210 away from the cell 110. That is, a portion of the exposed portion 210 extending out of the opening 321 is located in the avoidance structure 331 of the insulating spacer layer 330.

Referring to FIG. 9, there is an insulating glue 120 further provided on the back surface of the cell 110. The insulating glue 120 is configured to insulate the first electrodes from the second electrodes of the respective cell 110. Since the film-coating layer 320 is provided on the back surface of the cell 110, the film-coating layer 320 can protect most of the electrode regions of the cell 110, and thus the amount of the insulating glue 120 can be reduced.

Referring to FIG. 9, in some embodiments, the insulating glue 120 is provided between the solder ribbons 200 and the back surface of the respective cell 110. A size of the insulating glue 120 in the arrangement direction of the solder ribbons 200 (the extending direction of the bus bar) is greater than or equal to a size of the opening 321 in the arrangement direction of the solder ribbons 200, so that a projection of the opening 321 on the back surface of the cell 110 is located on the insulating glue 120.

Specifically, the size of the insulating glue 120 in the extending direction of the bus bar 400 is regarded as a width of the insulating glue 120, and the size of the opening 321 in the extending direction of the bus bar 400 is regarded as a width of the opening 321. The width of the opening 321 is larger than a width of the solder ribbon 200, and the width of the insulating glue 120 is larger than or equal to the width of the opening 321 in the extending direction of the bus bar 400, so that a portion of the back surface of the cell 110 exposed from the opening 321 includes the exposed portion 210 and the insulating glue 120. That is, a region of the back surface of the cell 110 except the exposed portion 210 is covered by the insulating glue 120 and the film-coating layer 320. In this way, the film-coating layer 320 is opened to expose the exposed portions 210. As long as the openings in the film-coating layer 320 are properly positioned, the solar cell 110 will be protected by the insulating glue 120 and the film-coating layer 320 after soldering (even with solder splashing) of the bus bar 400, thereby preventing foreign objects from bridging the electrodes of the cells 110 to avoid short circuits of the cells.

Furthermore, embodiments of the present disclosure further provide a photovoltaic module. The photovoltaic module includes: cell strings, insulating layers, bus bars, and conductive bridge portions. Each respective cell string of the cell strings includes a plurality of cells, and each respective cell of the plurality of cells is provided with solder ribbons on a back surface of the respective cell, where the solder ribbons disposed on the plurality of cells are configured to connect the plurality of cells in series. A respective insulating layer of the insulating layers is disposed on a side of the solder ribbons away from the respective cell, and the respective insulating layer defines windows, a respective window of the windows to allow a corresponding exposed portion of a respective solder ribbon to be exposed through the respective window. A respective bus bar of the bus bars is disposed on a side of the respective insulating layer away from the solder ribbons. A respective conductive bridge portion of the conductive bridge portions is provided between the respective bus bar and the corresponding exposed portion, to electrically connect the respective bus bar and the corresponding exposed portion through the respective conductive bridge portion.

In some embodiments, the conductive bridge portion is a bridge connector or a conductive adhesive.

In some embodiments, the conductive bridge is a bridge connection, where the bridge connector and the exposed portion are integrally formed; and/or, the bridge connector has a width greater than a width of the respective solder ribbon in an arrangement direction of the solder ribbons.

In some embodiments, the respective insulating layer includes a film-coating layer, the film-coating layer is disposed on the respective cell string, and the film-coating layer covers the back surface of the respective cell and the solder ribbons on the back surface of the respective cell, where the film-coating layer defines openings, and each of the openings forms the respective window.

In some embodiments, the respective insulating layer further includes an insulating spacer layer, the insulating spacer layer is disposed between the film-coating layer and the respective bus bar, and the insulating spacer layer is provided with avoidance structures each communicating with a corresponding opening of the openings.

In some embodiments, an insulating glue is provided between the solder ribbons and the back surface of the respective cell, and the insulating glue has a size greater than or equal to a size of a corresponding opening of the openings in an extending direction of the respective bus bar, so that a projection of the corresponding opening on the back surface of the respective cell is located on the insulating glue.

In some embodiments, the film-coating layer is extended in the extending direction of the respective cell string, and the film-coating layer has a size equal to a length of the respective cell string in the extending direction of the respective cell string; or the film-coating layer includes a plurality of film-coating sublayers, the plurality of film-coating sublayers are in one-to-one correspondence with the plurality of cells in the respective cell string, and each of the plurality of film-coating sublayers covers the back surface of the respective cell.

In some embodiments, the insulating spacer layer is provided in a strip shape and extends in an extending direction of the respective bus bar, the insulating spacer layer defines clearance holes corresponding to the openings, and each of the clearance holes forms a corresponding avoidance structure of the avoidance structures.

In some embodiments, the insulating spacer layer includes a plurality of insulating sublayers arranged at intervals in the extending direction of the respective bus bar, and each two adjacent insulating sublayers are spaced by the corresponding opening to form the corresponding avoidance structure between the two adjacent insulating sublayers.

In some embodiments, a plurality of openings are defined at intervals in the extending direction of the respective bus bar, and there are insulating sublayers on both sides of each opening in the extending direction of the respective bus bar.

The technical solution provided in embodiments of the present disclosure has at least the following advantages.

The bus bars of the photovoltaic module are hidden on the back side of the cells, so the bus bars do not occupy the area on the front side of the photovoltaic module, thereby maximizing the laying area of the cells and increasing the light-receiving area on the front side of the photovoltaic module, thus improving the maximum output power of the photovoltaic module. In addition, providing a conductive bridge portion to the contact position between the bus bar and the solder ribbon can not only effectively reduce the risk of cracks and fragments of the cells in the subsequent lamination process, but also reduce the risk of false/poor soldering between the bus bar and the solder ribbons.

Specifically, FIGS. 5 to 6, 8 to 9, and 11 to 14 are schematic structural views of various photovoltaic modules provided in embodiments of the present disclosure.

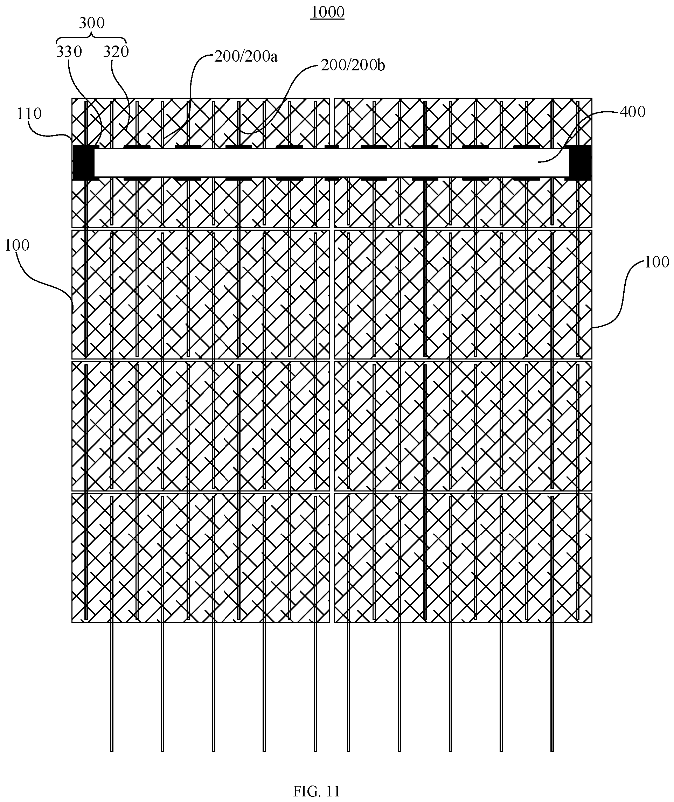

Referring to FIGS. 11 to 13, the photovoltaic module 1000 includes a plurality of cell strings 100, insulating layers 300, bus bars 400, and conductive bridge portions 500. Each of the plurality of cell strings 100 includes a plurality of cells 110. Each respective cell 110 of the plurality of cells 110 is provided with solder ribbons 200 on a back surface of the respective cell 110, where the solder ribbons 200 disposed on the plurality of cells 110 are configured to connect the plurality of cells 110 in series. A respective insulating layer 300 of the insulating layers 300 is provided on a side of the solder ribbons 200 away from the respective cell 110. The respective insulating layer 300 defines windows 310, a respective window 310 of the windows 310 to allow an exposed portion 210 of a respective solder ribbon 200 to be exposed through the respective window 310. A respective bus bar 400 of the bus bars 400 is provided on a side of the respective insulating layer 300 away from the solder ribbons 200. A respective conductive bridge portion 500 of the conductive bridge portions 500 is provided between the respective bus bar 400 and a corresponding exposed portion 210, to electrically connect the respective bus bar 400 and the respective solder ribbon 200 through the respective conductive bridge portion 500.

Specifically, the photovoltaic module 1000 is a back contact cell module. The photovoltaic module 1000 includes a plurality of cell strings 100 connected in series, and each cell string 100 includes a plurality of cells 110 connected in series. Each cell 110 is generally a sheet-like structure, and the cell 110 has a front surface (or light absorbing surface) and a back surface opposite in a thickness direction of the cell 110 (in a direction perpendicular to the back surface of the respective cell 110). The front surface of the cell 110 can absorb light energy and convert the light energy into electrical energy. The cell 110 includes first grid lines (electrodes) and second electrodes on the back surface of the cell 110. One of the first electrode and the second electrode is a positive electrode and the other of the first electrode and the second electrode is a negative electrode. That is, the first electrode and the second electrode have different conductivity types. There are the solder ribbons 200 disposed on the back surface of the respective cell 110, and each solder ribbon 200 of the solder ribbons 200 extends in a longitudinal/extending direction of a respective cell string 100 (that is, an arrangement direction of the plurality of cells 110 in the respective cell string 100). The solder ribbons 200 include a plurality of first solder ribbons 200a and a plurality of second solder ribbons 200b. The plurality of first solder ribbons 200a and the plurality of second solder ribbons 200b are alternatingly disposed on the back surface of the respective cell 110 in a width direction of the respective cell string 100. A respective first solder ribbon 200a of the plurality of first solder ribbons 200a is electrically connected to a respective first electrode of the plurality of first electrodes, and a respective second solder ribbon 200b of the plurality of second solder ribbons 200b is electrically connected to a respective second electrode of the plurality of second electrodes. In this way, current of the first electrodes can be conducted by the first solder ribbons 200a, the current of the second electrodes can also be conducted by the second solder ribbons 200b, and the plurality of cells 110 in the respective cell string 100 are connected in series by the first solder ribbons 200a and the second solder ribbons 200b on the back surface of each cell 110.

The respective insulating layer 300 is provided on the side of the solder ribbons 200 away from the cells 110. That is, the respective insulating layer 300 covers the solder ribbons 200 and a region of the back surface of the respective cell other than the solder ribbons 200. The respective insulating layer 300 defines windows 310. A portion of the respective solder ribbon 200 facing the respective window 310 of the windows 310 in the thickness direction of the respective cell 110 is defined as an exposed portion 210. That is, the respective window 310 exposes the exposed portion 210 of the solder ribbon 200. In other words, the exposed portion 210 of the respective solder ribbon 200 is not covered by the respective insulating layer 300, and another portion of the respective solder ribbon 200 except the exposed portion 210 is covered by the respective insulating layer 300. The respective bus bar 400 is provided on the side of the respective insulating layer 300 away from the solder ribbons 200, and a respective portion of the respective bus bar 400 faces the corresponding exposed portion 210 at a distance in the thickness direction of the cell 110. A respective conductive bridge portion 500 is provided at a respective window 310 of the respective insulating layer 300, and the respective conductive bridge portion 500 is located between the corresponding exposed portion 210 and the respective bus bar 400. The respective conductive bridge portion 500 electrically connects the corresponding exposed portion 210 and the respective bus bar 400, so that the respective bus bar 400 and the corresponding solder ribbon 200 are electrically connected by the respective conductive bridge portion 500. In this way, a conductive bridge portion 500 is provided at the contact position between the bus bar 400 and the solder ribbon 200, so that the contact position between the bus bar 400 and the solder ribbon 200 can be flat, thereby improving the stress concentration and local deformation generated in the subsequent lamination process of the cells 110.

The respective bus bar 400 is electrically connected to the respective solder ribbon 200, specifically, the respective bus bar 400 is electrically connected to one of the first solder ribbon 200a and the second solder ribbon 200b. For example, referring to FIGS. 11 to 13, in some embodiments, the respective insulating layer 300 defines a window 310 corresponding to each of the first solder ribbons 200a, and the respective bus bar 400 is electrically connected to a corresponding first solder ribbon 200a through a corresponding conductive bridge portion 500. For another example, in other embodiments, the respective insulating layer 300 defines a window 310 corresponding to each of the second solder ribbons 200b, and the respective bus bar 400 is electrically connected to a corresponding second solder ribbon 200b through a corresponding conductive bridge portion 500. Hereinafter, the following describes the respective bus bar 400 being electrically connected to the corresponding first solder ribbon 200a through the corresponding conductive bridge portion 500 as an example of the respective bus bar 400 being electrically connected to the corresponding solder ribbon 200.

The bus bars 400 of the photovoltaic module 1000 are disposed on the back surface of each of the cells 110, and the bus bars 400 do not occupy the area of the front surface of the photovoltaic module 1000, thereby maximizing the laying area of the cells 110, increasing the illumination area of the front surface of the photovoltaic module 1000, and thus, increasing the maximum output power of the photovoltaic module 1000. Providing the conductive bridge portion 500 to the contact position between the bus bar 400 and the solder ribbon 200 can not only effectively reduce the risk of cracking and fragmentation of the cells 110 in the subsequent lamination process, but also reduce the possibility of virtual welding between the bus bar 400 and the solder ribbons 200.

Hereinafter, embodiments of the present disclosure will be described in more detail with reference to the drawings.

The respective bus bar 400 and the respective solder ribbon 200 are electrically connected by a corresponding conductive bridge portion 500, and the conductive bridge portion 500 is configured in a variety of specific ways. For example, the conductive bridge portion 500 may be a bridge connector 500a, such as, a segment of solder ribbon or a metal piece. Alternatively, the conductive bridge portion 500 may be a conductive adhesive. Alternatively, the conductive bridge portion 500 may also be a combination of the bridge connector 500a and the conductive adhesive.

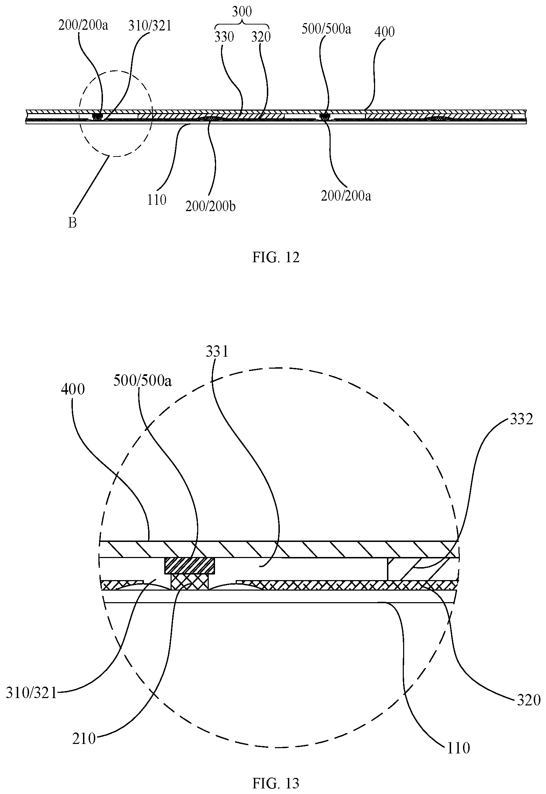

Referring to FIGS. 12 and 13, in some embodiments, the conductive bridge portion 500 is a bridge connector 500a, and the bridge connector 500a is a segment of solder ribbon. The segment of solder ribbon is used as the conductive bridge portion 500, which provides a relatively simple configuration method.

When the conductive bridge portion 500 is a bridge connector 500a, the bridge connector 500a and the exposed portion 210 may be integrally formed, or the bridge connector 500a and the exposed portion 210 may be provided separately.

The respective bridge connector 500a has a thickness in a thickness direction of the corresponding solder ribbon 200 (in a direction perpendicular to the back surface of the respective cell 110). A height difference between the bus bar 400 and the solder ribbon 200 is equal to or approximately equal to the thickness of the bridge connector 500a, so that the contact position between the bus bar 400 and the solder ribbon 200 can be relatively flat.

The respective bridge connector 500a has a length in a longitudinal/extending direction of the corresponding solder ribbon 200, and the length of the bridge connector 500a is less than or equal to a length of the exposed portion 210. Referring to FIGS. 12 to 13, in some embodiments, the length of the respective bridge connector 500a is equal to the length of the exposed portion 210 in the extending direction of the corresponding solder ribbon 200. By maximizing the length of the bridge connector 500a, not only is it beneficial to increase the effective conductive area between the bus bar 400 and the solder ribbon 200, but also can avoid gaps between the bus bar 400 and the solder ribbon 200 in the extending direction of the solder ribbon 200, so that the contact position between the bus bar 400 and the solder ribbon 200 can be relatively flat.

The respective bridge connector 500a has a width in a width direction of the solder ribbon 200 (in the extending direction of the bus bar 400), and the width of the bridge connector 500a may be greater than or equal to a width of the solder ribbon 200. Alternatively, the width of the bridge connector 500a may also be smaller than the width of the solder ribbon 200. Referring to FIGS. 12 and 13, in some embodiments, the width of the bridge connector 500a is greater than the width of the solder ribbon 200. The solder ribbon 200 is generally configured with a uniform width, and the width of the solder ribbon 200 is the width of the exposed portion 210. The width of the bridge connector 500a is set to be slightly larger than the width of the exposed portion 210, which is not only beneficial to increasing the effective conductive area between the bus bar 400 and the solder ribbon 200, but also avoiding a gap between the bus bar 400 and the solder ribbon 200 in the width direction of the solder ribbon 200, so that the contact position between the bus bar 400 and the solder ribbon 200 can be relatively flat.

Referring to FIGS. 11, 5, and 6, each cell of each cell string 100 is generally provided with a plurality of first solder ribbons 200a in a width direction of the cell string 100 (an extending direction of the respective bus bar), and the plurality of first solder ribbons 200a are electrically connected by the respective bus bar 400. For example, referring to FIGS. 11, 5, and 6, in some embodiments, the respective insulating layer 300 defines a plurality of windows 310 arranged at intervals in the extending direction of the respective bus bar 400, so that each cell string 100 is formed with a plurality of exposed portions 210 arranged at intervals in the extending direction of the bus bar 400. There are a plurality of conductive bridge portions 500 corresponding, respectively, to the plurality of exposed portions 210 in the cell string 100. Each of the plurality of exposed portions 210 is electrically connected to the respective bus bar 400 through a corresponding conductive bridge portion 500. Here, the extending direction of the bus bar 400 is perpendicular to or approximately perpendicular to the extending direction of the solder ribbon 200. This arrangement can lay more cells 110, which is beneficial to increasing the laying area of the cells.

Referring to FIGS. 11, 5, and 6, the photovoltaic module 1000 generally includes a plurality of cell strings 100, and the plurality of cell strings 100 are connected in series by bus bars 400. For example, referring to FIGS. 11, 5, and 6, in some embodiments, the plurality of cell strings 100 are arranged in the extending direction of the respective bus bar 400, and the plurality of cell strings 100 are connected in series by the bus bars 400. In this way, the cells 110 may be arranged more densely, which is beneficial to increasing the laying area of the cells 110.

The respective insulating layer 300 is provided between the respective bus bar 400 and the solder ribbons 200, and the respective insulating layer 300 is configured to insulate the respective bus bar 400 from the second solder ribbons 200b and the second electrodes of the respective cell 110. Since the respective insulating layer 300 defines a respective window 310 corresponding to the exposed portion 210 of each of the first solder ribbons 200a, the respective bus bar 400 can be electrically connected to a corresponding first solder ribbon 200a through a corresponding conductive bridge portion 500 provided at the respective window 310.

The insulating layer 300 can be provided in a variety of ways. For example, the insulating layer 300 may be an insulating glue, an insulating tape, an insulating film, or the like. Referring to FIGS. 11, 5, and 6, in some embodiments, the respective insulating layer 300 includes a film-coating layer 320, the film-coating layer 320 is disposed on the respective cell string 100, and the film-coating layer 320 covers the solder ribbons 200 and a region of the back surface of each of the cells 110 other than the solder ribbons 200. The film-coating layer 320 defines openings 321, and each of the openings 321 forms a respective window 310.

For the arrangement of the insulating layers, and the arrangement of the film-coating layer 320 and the arrangement of the insulating spacer layer 330 in the insulating layer, reference may be made to the above-described embodiments, which will not be repeated herein. For example, the film-coating layer 320 defines openings 321 and the insulating spacer layer 330 is provided with avoidance structures 331 each communicating with a corresponding one of the openings 321.

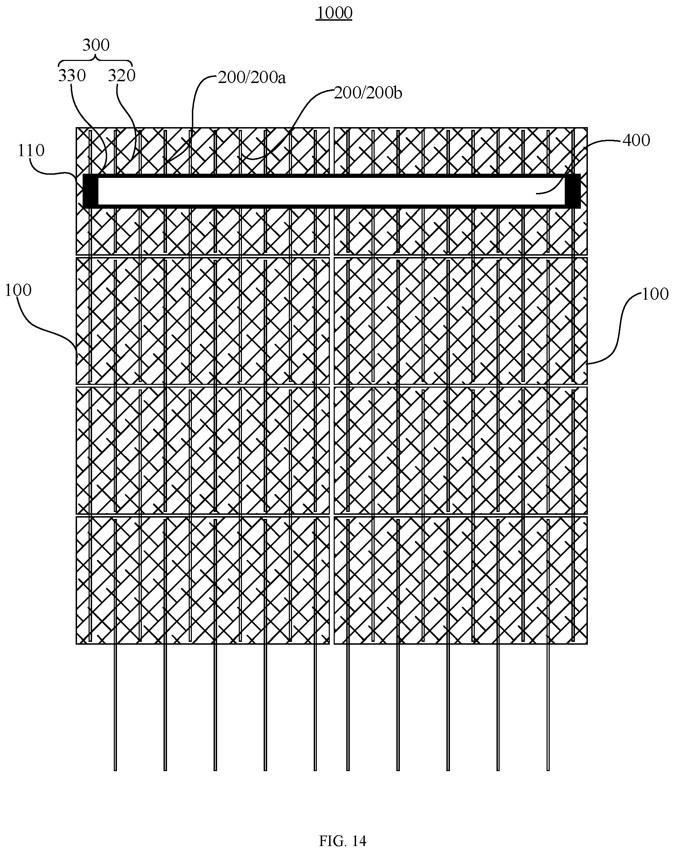

Referring to FIGS. 14 and 8, in some embodiments, the respective insulating spacer layer 330 is provided in a strip shape extending in the extending direction of the respective bus bar 400, and the respective insulating spacer layer 330 defines clearance holes 331a corresponding to the openings 321, where each of the clearance holes 331a forms a corresponding avoidance structure 331.

Specifically, the respective insulating spacer layer 330 is shaped to match the respective bus bar 400, and the respective insulating spacer layer 330 is provided in an elongated strip shape. A length of the respective insulating spacer layer 330 (in the extending direction of the respective bus bar) is greater than or equal to the length of the respective bus bar 400, and a width of the respective insulating spacer layer 330 (in the extending direction of the solder ribbon) is greater than or equal to a width of the respective bus bar 400. For example, the length of the insulating spacer layer 330 may be slightly larger than the length of the bus bar 400, and the width of the insulating spacer layer 330 may also be slightly larger than the width of the bus bar 400. The respective insulating spacer layer 330 defines a plurality of clearance holes 331a corresponding to the openings 321 of the film-coating layer 320, and each of the plurality of clearance holes 331a communicates with a corresponding one of the openings 321. A size of a respective clearance hole 331a may be greater than or equal to a size of a respective opening 321, and the respective clearance hole 331a is generally shaped to match the respective opening 321. For example, referring to FIGS. 14 and 8, in some embodiments, the clearance holes 331a and the openings 321 include square holes. By providing the insulating spacer layer 330 in an elongated strip shape, a gap between the bus bar 400 and the film-coating layer 320 can be avoided, and the contact position between the bus bar 400 and the solder ribbon 200 can be relatively flat.

Each solder ribbon 200 has a thickness less than a sum of a thickness of the film-coating layer 320 and a thickness of the insulating spacer layer 330 and the thickness of the solder ribbon 200 may be greater than the thickness of the film-coating layer 320, in a direction perpendicular to the back surface of the respective cell. Alternatively, the thickness of the solder ribbon 200 may be equal to the thickness of the film-coating layer 320. Alternatively, the thickness of the solder ribbon 200 may also be less than the thickness of the film-coating layer 320. Referring to FIG. 13, in some embodiments, a surface of the exposed portion 210 away from the cell 110 is located on a side of the film-coating layer 320 close to the insulating spacer layer 330, and a surface of the insulating spacer layer 330 close to the bus bar 400 is located on the side of the exposed portion 210 away from the cell 110.

Specifically, if a width of the respective opening is larger than a width of the respective solder ribbon 200 in the extending direction of the bus bar 400, and the thickness of the solder ribbon 200 is greater than the thickness of the film-coating layer 320, the surface of the exposed portion 210 away from the cell 110 is located on a side of a portion of the film-coating layer 320 that does not cover the solder ribbon 200 close to the insulating spacer layer 330. That is, the exposed portion 210 extends toward the bus bar 400 to the outside of the opening 321 of the film-coating layer 320. The thickness of the solder ribbon 200 is less than the sum of the thickness of the film-coating layer 320 and the thickness of the insulating spacer layer 330, so that the surface of the insulating spacer layer 330 close to the bus bar 400 is located on the side of the exposed portion 210 away from the cell 110. That is, a portion of the exposed portion 210 extending out of the opening 321 is located in the avoidance structure 331 of the insulating spacer layer 330.

Referring to FIG. 9, there is an insulating glue 120 further provided on the back surface of the cell 110. The insulating glue 120 is configured to insulate the first electrodes from the second electrodes of the cell 110. Since the film-coating layer 320 is provided on the back surface of the cell 110, the film-coating layer 320 can protect most of the electrode regions of the cell 110, and thus the amount of the insulating glue 120 can be reduced.

Referring to FIG. 9, in some embodiments, the insulating glue 120 is provided between the solder ribbons 200 and the back surface of the cell 110. A size of the insulating glue 120 in the arrangement direction of the solder ribbons 200 (the extending direction of the bus bar) is greater than or equal to a size of the opening 321 in the arrangement direction of the solder ribbons 200, so that a projection of the opening 321 on the back surface of the cell 110 is located on the insulating glue 120.

Specifically, the size of the insulating glue 120 in the arrangement direction of the solder ribbons 200 is regarded as a width of the insulating glue 120, and the size of the opening 321 in the arrangement direction of the solder ribbons 200 is regarded as a width of the opening 321. The width of the opening 321 is larger than the width of the solder ribbon 200, and the width of the insulating glue 120 is larger than or equal to the width of the opening 321, so that a portion of the back surface of the cell 110 exposed from the opening 321 includes the exposed portion 210 and the insulating glue 120. That is, a region of the back surface of the cell 110 except the exposed portion 210 is covered by the insulating glue 120 and the film-coating layer 320. In this way, the film-coating layer 320 is opened to expose the exposed portions 210. As long as the openings in the film-coating layer 320 are properly positioned, the solar cell 110 will be protected by the insulating glue 120 and the film-coating layer 320 after soldering (even with solder splashing) of the bus bar 400, thereby preventing foreign objects from bridging the electrodes of the cells 110 to avoid short circuits of the cells.

Those skilled in the art will understand that the above-described embodiments are specific embodiments for implementing the present disclosure, and various changes in form and details can be made thereto in practical application without departing from the spirit and scope of the present disclosure. Any person skilled in the art can make various changes and modifications without departing from the spirit and scope of the present disclosure, and therefore, the scope of protection of the present disclosure should be based on the scope defined by the claims.

## Claims

1. A photovoltaic module (1000), comprising:
cell strings (100), wherein each respective cell string (100) of the cell strings (100) includes a plurality of cells (110) sequentially arranged in a first direction (X), and each respective cell (110) of the plurality of cells (110) is provided with solder ribbons (200) on a back surface of the respective cell (110) and arranged in a second direction (Y) intersecting the first direction (X), wherein the solder ribbons (200) disposed on the plurality of cells (110) are configured to connect the plurality of cells (110) in series;
insulating layers (300), wherein a respective insulating layer (300) of the insulating layers (300) is disposed on a side of the solder ribbons (200) away from the respective cell (110), and the respective insulating layer (300) defines windows (310), a respective window (310) of the windows (310) to allow an exposed portion (210) of a respective solder ribbon (200) to be exposed through the respective window (310); and
bus bars (400), wherein a respective bus bar (400) of the bus bars (400) is disposed on a side of the respective insulating layer (300) away from the solder ribbons (200) and extends in the second direction (Y), and the respective bus bar (400) is provided with contact portions (410), wherein a respective contact portion (410) of the contact portions (410) recedes toward and abuts on a corresponding exposed portion (210), to electrically connect the respective bus bar (400) with the respective solder ribbon (200).

2. The photovoltaic module of claim 1, wherein a corresponding portion of the respective bus bar (400) is recessed toward the corresponding exposed portion (210) with respect to an adjacent portion of the respective bus bar (400) to form the respective contact portion (410).

3. The photovoltaic module of claim 1 or 2, wherein the respective contact portion (410) is arc-shaped.

4. The photovoltaic module of claim 1 or 2, wherein the respective contact portion (410) has a size equal to a width of the respective bus bar (400) in the first direction (X).

5. The photovoltaic module of any of claims 1 to 4, wherein the respective contact portion (410) and the corresponding exposed portion (210) are connected through a conductive adhesive, so that at least a portion of the respective contact portion (410) abuts on the corresponding exposed portion (210) through the conductive adhesive.

6. The photovoltaic module of any of claims 1 to 5, wherein the respective cell string (100) includes a plurality of exposed portions (210) arranged at intervals in the second direction (Y), the respective bus bar (400) is provided with a plurality of contact portions (410) corresponding to the plurality of exposed portions (210) in the respective cell string (100), and each of the plurality of exposed portions (210) abuts on a corresponding one of the plurality of contact portions (410).

7. The photovoltaic module of any of claims 1 to 6, wherein the cell strings (100) are arranged in the second direction (Y), and the cell strings (100) are connected in series through the bus bars (400).

8. The photovoltaic module of any of claims 1 to 7, wherein the respective insulating layer (300) includes a film-coating layer (320), the film-coating layer (320) is disposed on the respective cell string (100), and the film-coating layer (320) coves the solder ribbons (200) and a region of the back surface of the respective cell (110) other than the solder ribbons (200), wherein the film-coating layer (320) defines openings (321), and each of the openings (321) forms the respective window (310);
optionally, the film-coating layer (320) includes a plurality of film-coating sublayers (322), the plurality of film-coating sublayers (322) are in one-to-one correspondence with the plurality of cells (110) in the respective cell string (100), and each of the plurality of film-coating sublayers (322) covers the back surface of the respective cell (110).

9. The photovoltaic module of claim 8, wherein the respective insulating layer (300) further comprises an insulating spacer layer (330), the insulating spacer layer (330) is disposed between the film-coating layer (320) and the respective bus bar (400), and the insulating spacer layer (330) is provided with avoidance structures (331) each communicating with a corresponding opening (321) of the openings (321).

10. The photovoltaic module of claim 9, wherein the insulating spacer layer (330) is provided in a strip shape and extends in the second direction (Y), the insulating spacer layer (330) defines clearance holes (331a) corresponding to the openings (321), and each of the clearance holes (331a) forms a corresponding avoidance structure (331) of the avoidance structures (331), wherein the respective contact portion (410) extends into a corresponding clearance hole (331a), and the respective contact portion (410) abuts against an inner wall of the corresponding clearance hole (331a) in the second direction (Y);
optionally, the insulating spacer layer (330) includes a plurality of insulating sublayers (332) arranged at intervals in the second direction (Y), and each two adjacent insulating sublayers (332) are spaced by the corresponding opening (321) to form the corresponding avoidance structure (331) between the two adjacent insulating sublayers (332), wherein the respective contact portion (410) extends between the two adjacent insulating sublayers (332), and the respective contact portion (410) abuts against the two adjacent insulating sublayers (332) in the second direction (Y).

11. The photovoltaic module of claim 9, wherein the film-coating layer (320) has thermoplasticity better than that of the insulating spacer layer (330);
optionally, the film-coating layer (320) is extended in the first direction (X), and the film-coating layer (320) has a size equal to a length of the respective cell string (100) in the first direction (X).

12. The photovoltaic module of claim 9, wherein the insulating spacer layer (330) has a thickness in a range of 0.03 mm to 0.2 mm in a direction perpendicular to the back surface of the respective cell (110);
optionally, the respective solder ribbon (200) has a thickness less than a sum of a thickness of the film-coating layer (320) and the thickness of the insulating spacer layer (330), and the thickness of the respective solder ribbon (200) is greater than a thickness of the film-coating layer (320), in a direction perpendicular to the back surface of the respective cell (110).

13. The photovoltaic module of claim 8, wherein an insulating glue (120) is provided between the solder ribbons (200) and the back surface of the respective cell (110), and the insulating glue (120) has a size greater than or equal to a size of a corresponding opening (321) of the openings (321) in second direction (Y);
optionally, the corresponding opening (321) of the openings (321) includes a square hole.

14. The photovoltaic module of any of claims 1 to 13, wherein the respective cell (110) includes first electrodes and second electrodes having different conductive types from the first electrodes on the back surface of the respective cell (110), the solder ribbons (200) include first solder ribbons (200a) and second solder ribbons (200b), and the first solder ribbons (200a) and the second solder ribbons (200b) are alternatingly arranged on the back surface of the respective cell (110) in the second direction (Y), wherein each of the first solder ribbons (200a) is electrically connected to a corresponding first electrode of the first electrodes, and each of the second solder ribbons (200b) is electrically connected to a corresponding second electrode of the second electrodes, wherein the respective insulating layer (300) is configured to insulate the respective bus bar (400) from the first solder ribbons (200a) or the second solder ribbons (200b).

15. The photovoltaic module of any of claims 1 to 14, wherein a surface of the respective bus bar (400) close to the exposed portions (210) forms protrusions, and each of the protrusions is the respective contact portion (410).
